(19) Europäisches Patentamt
European Patent Office
Office européen des brevets

(11) EP 2 187 449 A1

(12) EUROPEAN PATENT APPLICATION
published in accordance with Art. 153(4) EPC

(43) Date of publication:
19.05.2010 Bulletin 2010/20

(51) Int Cl.:
*H01L 31/042* (2006.01)

(21) Application number: 07792513.9

(22) Date of filing: 14.08.2007

(86) International application number:
PCT/JP2007/065870

(87) International publication number:
WO 2009/022414 (19.02.2009 Gazette 2009/08)

(84) Designated Contracting States:
AT BE BG CH CY CZ DE DK EE ES FI FR GB GR
HU IE IS IT LI LT LU LV MC MT NL PL PT RO SE
SI SK TR
Designated Extension States:
AL BA HR MK RS

(71) Applicant: Mitsubishi Heavy Industries, Ltd.
Tokyo 108-8215 (JP)

(72) Inventors:
• TAKANO, Akemi
Nagasaki-shi
Nagasaki 851-0392 (JP)

• HORIOKA, Tatsuji
Nagasaki-shi
Nagasaki 850-8610 (JP)
• KOKAJI, Satoshi
Nagasaki-shi
Nagasaki 850-8610 (JP)
• UDA, Kazutaka
Nagasaki-shi
Nagasaki 851-0392 (JP)

(74) Representative: Bongiovanni, Simone et al
Studio Torta S.r.l
Via Viotti 9
I-10121 Torino (IT)

(54) **PHOTOELECTRIC CONVERSION DEVICE, AND ITS MANUFACTURING METHOD**

(57) A photovoltaic device that can prevent performance degradation caused by electrodeposition generated as a result of moisture penetration. In the photovoltaic device, two or more intermediate insulation portions 17 that electrically insulate solar cell unit cells 5 positioned adjacently in the X-direction are formed on the substrate center side of side insulation portions 16 so as to extend in the Y-direction in a parallel arrangement across the X-direction, a conductive portion 18 that electrically connects solar cell unit cells 5 positioned adjacently in the X-direction is provided in a position partway along each of the intermediate insulation portions 17, and the solar cell unit cells 5 where the conductive portion 18 is positioned are electrically insulated from a solar cell unit cell 5 positioned adjacently in the X-direction by another of the intermediate insulation portions 17 positioned distant from the conductive portion 18 in the X-direction.

FIG. 1

## Description

Technical Field

The present invention relates to a photovoltaic device and a process for producing the same, and relates particularly to a thin-film silicon stacked solar cell that uses silicon as the photovoltaic layer.

Background Art

The use of silicon-based thin-film photovoltaic devices as photovoltaic devices such as solar cells is already known. These photovoltaic devices generally comprise a transparent electrode, a silicon-based semiconductor layer (a photovoltaic layer), and a back electrode stacked sequentially on top of a transparent substrate. The semiconductor layer has a pin junction formed by p-type, i-type, and n-type semiconductor materials. In those cases where the photovoltaic device is a solar cell, this pin junction functions as the energy conversion unit, converting the light energy from sunlight into electrical energy.
Further, in a thin-film photovoltaic device, in order to achieve a desired level of output, a plurality of solar cell unit cells (photovoltaic cells) each having a transparent electrode, a photovoltaic layer and a back electrode, and in which a predetermined region is specified as a single unit, are generally connected electrically in a series arrangement to form an integrated structure.

Patent Literature 1 discloses an integrated thin-film solar cell module in which series-connected solar cell unit cells are insulated by isolation slots to form a plurality of sub-modules (a series array), and each of the sub-modules is connected electrically in a parallel arrangement to common electrodes provided at both ends of the panel. Employing this type of structure means that if a faulty cell is contained within one of the sub-modules, then by utilizing the other parallel-connected good sub-modules, any reduction in the overall output of the module caused by the faulty cell can be significantly alleviated compared with the case where only a single module is formed on a single substrate.

Patent Literature 2 discloses a process in which, for a structure comprising a plurality of photovoltaic cells connected electrically in a series arrangement, by causing electrical shorts by not completely isolating the cells at the positive electrode and negative electrode, or cells positioned close thereto, from the peripheral region with peripheral isolation slots, but then, following completion of a water cleaning step, removing these electrical shorts by forming a complete peripheral isolation slot, short-circuits that occur between the photovoltaic cell integrated region and the peripheral region as a result of ion migration within the peripheral isolation slots can be prevented.
Furthermore, in the water cleaning step for this photovoltaic device, by conducting the water cleaning inside a water cleaning chamber that is shielded from the light, the solar cell is prevented from generating photovoltaic power during the water cleaning step, thereby preventing short-circuits caused by ion migration.

Patent Literature

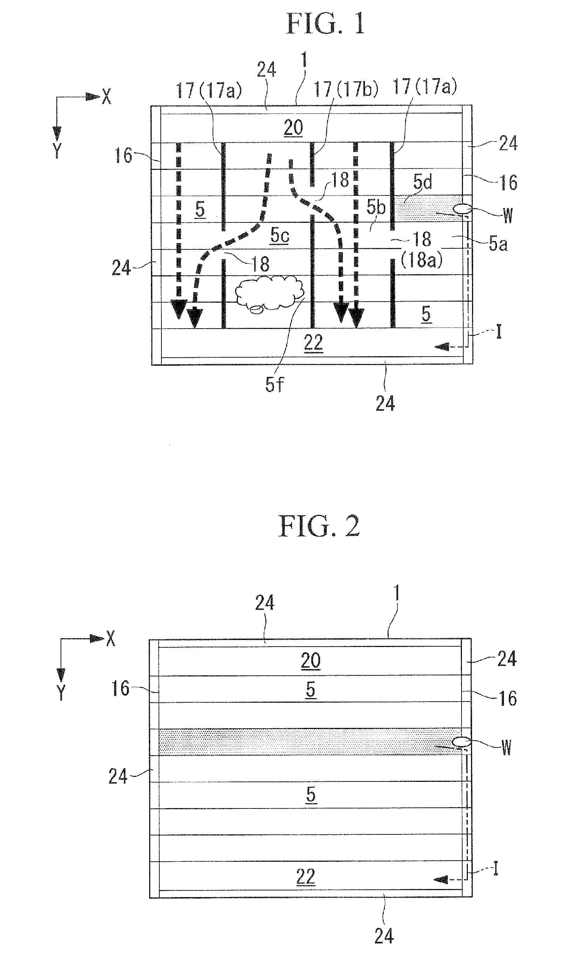

{PTL 1}
Japanese Unexamined Patent Application, Publication No. Hei 11-312816 (paragraph [0009] and Fig. 1)
{PTL 2}
Japanese Unexamined Patent Application, Publication No. Hei 10-209477 ([Example 1] and [Example 3])

Summary of Invention

On the other hand, as illustrated in Fig. 2, in a solar cell having a structure in which a plurality of solar cell unit cells 5 are connected electrically in series from a positive electrode 20 through to a negative electrode 22, a side insulation slot (side insulation portion) 16 that electrically insulates the solar cell layer in a central region of the substrate from the solar cell layer formed on an edge portion 24 of the substrate 1 is formed with a width of approximately 50 to 100 μm. Because positioning a mask precisely on the surface of the substrate during the production steps is a complex task, the solar cell layer on the edge portion 24 of the substrate is formed when each of the layers of the solar cell layer and the like are deposited on the entire substrate, and is an unavoidable result of targeting mass production.

The edge portion 24 of the substrate acts as a sealing and bonding surface that is used for bonding, via an adhesive filler sheet of EVA or the like, a backing sheet 21 that functions as a protective sheet for protecting the solar cell layer. Accordingly, the solar cell layer formed on the edge portion 24 of the substrate is removed by grinding or blast polishing.

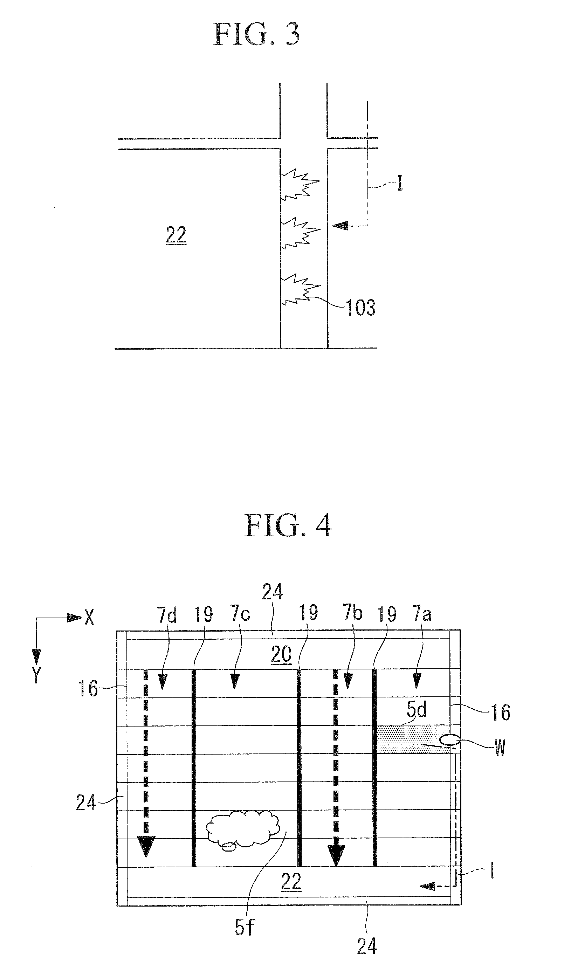

However, because there are limits to the dimensional precision of the polishing location during the removal of the solar cell layer formed on the edge portion 24 of the substrate, a solar cell layer having a width of several mm may be left unpolished on the outside of the side insulation slot 16. If the protective sheet is bonded in this state, with a portion of the solar cell layer remaining on the outside of the side insulation slot 16, and the cell is then used for an extended period of time, then the resulting deterioration in the waterproofing performance of the bonded portion may allow a small amount of water to penetrate the cell from the edge of the protective sheet, or may allow moisture to gradually penetrate into the cell in the form of water vapor. When water W that penetrates between the protective sheet and the substrate in this manner reaches the side insulation slot 16, then as illustrated in Fig. 2, a short-circuit can occur between the solar cell 5, which is isolated by the side insulation slot 16 and functions as an electric power generation region, and the solar cell layer remaining on the outside of the side insulation slot 16, thereby forming an electrical circuit that leads to the negative electrode 22. When this occurs, then as illustrated in the enlarged view of the vicinity of the corner of the negative electrode 22 shown in Fig. 3, the metal (such as silver) used as the back electrode of the solar cell unit cell 5 dissolves due to a leakage current I arising from the electrical current generated by the solar cell layer, causing deposition (electrodeposition) 103 at the counter electrode. As this electrodeposition 103 proceeds, the deposited metal causes a short-circuit between the insulated portion produced by the side insulation slot 16 and the edge portion 24, resulting in a deterioration in the cell output performance of the solar cell.

Furthermore, the above type of electrodeposition within the insulation slot may also occur during the production of the solar cell. This is because, even during the production steps, following formation of the solar cell layer, the inside illumination used along the production line can cause electric power generation to occur within the solar cell layer, generating a photovoltaic force.

For example, following formation of the side insulation slot 16, a substrate cleaning step is performed. The water used during this cleaning step may adhere to the side insulation slot 16, causing electrodeposition and increasing the possibility of a short-circuit occurring from the insulation portion.

Further, even in cases such as those described in PTL 2, where the substrate cleaning step is performed after formation of the isolation slot, water that adheres within the isolation slot may still cause electrodeposition.

Furthermore, in PTL 1, creating sub-modules and then connecting these sub-modules in a parallel arrangement offers the advantage that even if one sub-module contains a faulty cell, the remaining healthy sub-modules can continue to be used, but also suffers the drawback that the sub-module that contains the faulty cell cannot be used as an electric power generation region.

Furthermore, even if, as in PTL 2, the positive electrode or negative electrode cell is not isolated by the side insulation slot, when the substrate cleaning step is performed, in the case of a solar cell formed on a large substrate, a voltage difference may still develop between cells positioned in distant locations from the positive electrode or negative electrode, meaning water that adheres in the side insulation slots may still cause electrodeposition.

Furthermore, in PTL2, although the solar cell water cleaning step is conducted inside a chamber that is surrounded by a light-blocking guard to prevent photovoltaic power from being generated during the water cleaning step, blocking light from entering the portions where the solar cell is transported into and out of the cleaning apparatus is problematic, and satisfactory prevention of ion migration (electrodeposition) has proven difficult.

Furthermore, in PTL 2, the side insulation slots 16 that were initially formed by an incomplete cut must be cut completely through following the cleaning step, which is not particularly suited to a mass production process.

The present invention has been developed in light of these circumstances, and has an object of providing a photovoltaic device which is capable of preventing deterioration in the performance of a solar cell caused by electrodeposition generated as a result of moisture penetration, and is also capable of suppressing, as far as possible, any deterioration in performance even when the device includes a photovoltaic cell (solar cell unit cell) that is unable to generate electric power, such as a faulty cell.

Here, the term "faulty cell" refers to a cell that is partially shielded from the light and therefore has a reduced electric power generation current, a cell that suffers from a low electric power generation current as an inherent cell property, or a cell in which the resistance of the transparent electrode or back electrode, or the contact resistance thereof, is high within some portions, resulting in a larger current collection loss.

Further, the present invention also has an object of providing a process for producing a photovoltaic device that is capable of avoiding the possibility of short-circuits caused by electrodeposition during the production steps.

In order to achieve the above objects, a photovoltaic device according to a first aspect of the present invention employs the configuration described below.

In other words, a photovoltaic device of the present invention comprises a plurality of photovoltaic cells, which are formed on top of a substrate and are connected in series in a first direction, and side insulation portions, which are formed continuously in the vicinity of the sides of the substrate that extend along the first direction and electrically insulate the photovoltaic cells from an edge portion of the substrate, wherein two or more intermediate insulation portions that electrically insulate the photovoltaic cells positioned adjacently in a second direction that is substantially orthogonal to the first direction are formed on the substrate center side of the side insulation portions so as to extend in the first direction in a parallel arrangement across the second direction, a conductive portion that electrically connects the photovoltaic cells positioned adjacently in the second direction is provided in a position partway along each of the intermediate insulation portions, and the photovoltaic cells where the conductive portion is positioned are electrically insulated from a photovoltaic cell positioned adjacently in the second direction by another of the intermediate insulation portions positioned distant from the conductive portion in the second direction.

Because the intermediate insulation portions (intermediate insulation slots) are provided on the substrate center side of the side insulation portions, the photovoltaic cells adjacent to the side insulation portions are limited in size to the surface area from the side insulation portion to the adjacent intermediate insulation portion. Accordingly, even if a side insulation portion short-circuits as a result of water penetration or the like, only an electric power generation current equivalent to the surface area between the side insulation portion and the intermediate insulation portion leaks into the edge portion of the substrate. In this manner, the intermediate insulation portions enable the leakage current generated when a short-circuit occurs to be reduced, meaning short-circuits caused by electrodeposition can be dramatically suppressed.

There are no particular restrictions on the configuration of the side insulation portions and the intermediate insulation portions, as long as they provide reliable electrical insulation between adjacent regions. Examples of preferred configurations include, for example, insulation slots, which can be generated following formation of the photovoltaic cells by using laser processing to remove the transparent electrode, the photovoltaic layer, and the back electrode layer across a predetermined slot width.

Furthermore, by providing the conductive portion in a position partway along each intermediate insulation portion, the adjacent photovoltaic cells on either side of this position are electrically connected. This means that the electric power generation current can also flow in the second direction through this conductive portion, meaning the electrical current can flow not only to the photovoltaic cell positioned adjacently in the first direction, but also via the conductive portion to the photovoltaic cell positioned adjacently in the second direction. Accordingly, even if an ineffective cell that does not contribute to electric power generation exists in the first direction, another photovoltaic cell positioned adjacently in the second direction can be used, meaning deterioration in the performance of the photovoltaic device can be prevented as far as possible.

There are no particular restrictions on the configuration of the conductive portions, provided they generate a reliable electrical connection. In a preferred configuration, each of the intermediate insulation portions formed in the first direction is divided at a position partway along the intermediate insulation portion, and this position where the intermediate insulation portion is not formed functions as a conductive portion. Further, in the case of photovoltaic cells formed by sequentially stacking a transparent electrode, a photovoltaic layer (including single structures, tandem structures and triple structures) and a back electrode layer on a transparent substrate, the back electrode layer and the transparent electrode layer preferably remain within the conductive portion. However, a region in which only the back electrode layer remains or a region in which only the transparent electrode layer remains can also be used as the conductive portion.

Furthermore, the photovoltaic cells where a conductive portion is positioned are electrically insulated from another photovoltaic cell positioned adjacently in the second direction due to another intermediate insulation portion. As a result, photovoltaic cells having a comparatively large surface area that are formed in a continuous manner from one side insulation portion through to the other side insulation portion can be avoided, thereby suppressing the size of the electrical current that flows when a short-circuit occurs within a side insulation portion as a result of water penetration or the like, and largely avoiding short-circuits caused by electrodeposition.

Moreover, in the photovoltaic device of the present invention, the intermediate insulation portions may include two first intermediate insulation portions, each provided next to one of the side insulation portions formed along both sides of the substrate, and at least one second intermediate insulation portion provided between the first intermediate insulation portions.

Because at least one second intermediate insulation portion is provided between the two first intermediate insulation portions, photovoltaic cells between the two first intermediate insulation portions are partitioned into at least two cells in the second direction. As a result, even if one photovoltaic cell becomes a faulty cell due to the state of the film deposition, the presence of shade, or the adhesion of dirt or the like, the group of photovoltaic cells positioned adjacently in the second direction and isolated by the second intermediate insulation portion can continue to be utilized for electric power generation, meaning any deterioration in the performance of the photovoltaic device can be largely suppressed.

Furthermore, even if a photovoltaic cell exists that has become faulty due to the state of the film deposition, the presence of shade, or the adhesion of dirt or the like, the electric power generation current can still flow through the conductive portion provided in the intermediate insulation portion into the photovoltaic cell positioned adjacently in the second direction, and therefore deterioration in the performance of the photovoltaic device can be suppressed even further.

Moreover, the photovoltaic device of the present invention may further comprise a protective sheet that covers an entire surface of the substrate so as to protect the photovoltaic cells formed on top of the substrate, wherein the intermediate insulation portions are positioned not less than 20 mm distant from the side insulation portions.

The protective sheet is installed on top of the substrate to protect the photovoltaic cells. When the photovoltaic device is used for an extended period of time, there is a possibility that the edges of the protective sheet may peel away from the substrate, or that the waterproofing and moisture-proofing performance of the sealed portion may deteriorate, allowing water or moisture from the outside atmosphere to penetrate into the photovoltaic cells. If the peeling of the edges of the protective sheet is minimal, then the moisture is blocked by the side insulation portions. However, if the peeling of the edges of the protective sheet progresses and the waterproofing and moisture-proofing performance of the sealed portion deteriorates further, then moisture may cross the side insulation portion and penetrate into the photovoltaic cells. In the present invention, because the intermediate insulation portions are formed not less than 20 mm distant from the side insulation portions, even if moisture crosses a side insulation portion and penetrates via the slot portion formed by the series connection of the plurality of photovoltaic cells, the adjacent intermediate insulation portion can block the penetration of the moisture, and those photovoltaic cells positioned on the inside of the intermediate insulation portion can continue to be used. According to investigations conducted by the inventors of the present invention and others, provided that the intermediate insulation portion is 20 mm distant from the side insulation portion, then even in those cases where the protective sheet peels as far as the side insulation portion, the intermediate insulation portion is able to block adverse effects to such an extent that 10 or more years are required before short-circuits due to water penetration or performance deterioration caused by cell degeneration become problematic.

The protective sheet is preferably a waterproof backing sheet that is bonded via an adhesive filler sheet such as EVA (ethylene vinyl acetate copolymer). A three-layer structure comprising a PET sheet, Al foil, and a PET sheet can be used favorably as the backing sheet.

Moreover, in the photovoltaic device of the present invention, the photovoltaic cells may exist within a single structure comprising a single photovoltaic layer, a tandem structure comprising two stacked photovoltaic layers, or a triple structure comprising three stacked photovoltaic layers.

Further, the electric power generation current increases with increasing size of the solar cell, and therefore in large solar cells where the length along one side exceeds 1 m, the present invention is effective even in single structures having a single electric power generation layer.

Moreover, photovoltaic cells having a tandem structure with two stacked photovoltaic layers or a triple structure with three stacked photovoltaic layers have larger electric power generation capacities than photovoltaic cells having a single structure with one photovoltaic layer, and therefore the potential leakage current is larger, which means there is an increased chance of electrodeposition causing short-circuits. Accordingly, in the case of photovoltaic cells having a tandem structure or a triple structure, a photovoltaic device comprising intermediate insulation portions, such as the device of the present invention described above, is particularly effective.

A process for producing a photovoltaic device according to the present invention comprises an insulation step of forming an insulation portion that electrically insulates a photovoltaic layer formed on a substrate from other regions, and a cleaning step of cleaning the substrate following the insulation step, wherein for a predetermined period including the cleaning step, the photovoltaic layer is illuminated with a red-colored light. This red-colored light is a red light having a wavelength of not less than approximately 650 nm, and preferably a wavelength of not less than 700 nm.

When the substrate is cleaned with water in a cleaning apparatus following completion of the insulation step, there is a possibility that water may accumulate within an insulation portion, causing the insulation portion to short-circuit, and increasing the likelihood of electrodeposition and subsequent short-circuits. In the present invention, for a predetermined period including the cleaning step, the photovoltaic layer is illuminated with a red-colored light, and light of a wavelength that causes the photovoltaic cells to contribute significantly to electric power generation is excluded as far as possible, and therefore an electric potential sufficient to cause electrodeposition is not generated within those insulation portions that have been short-circuited during the cleaning step. Accordingly, any chance that electrodeposition may occur during the production process for the photovoltaic device, causing a short-circuit, can be effectively eliminated. Here, the expression "predetermined period including the cleaning step" means a period that includes, at least, the period during which water supplied during the cleaning step causes short-circuits of the insulation portions.

Moreover, the process for producing a photovoltaic device according to the present invention is preferably used for producing one of the photovoltaic devices described above.

The photovoltaic devices according to each of the aspects of the present invention described above comprise intermediate insulation portions in addition to the side insulation portions, meaning there is an increased chance of electrodeposition occurring within the insulation portions and causing short-circuits, and therefore during the cleaning step, maintaining a state of illumination that employs mainly red-colored light, which enables operations inside the cleaning apparatus to be inspected visually while offering minimal contribution to electric power generation, is particularly effective.

{Brief Description of Drawings}

{Fig. 1} A plan view illustrating the structure of a photovoltaic device according to an embodiment of the present invention.

{Fig. 2} A plan view illustrating the structure of a conventional photovoltaic device.

{Fig. 3} An enlarged view illustrating the corner portion of the negative electrode in Fig. 2.

{Fig. 4} A plan view of a photovoltaic device illustrating a comparative example of the present invention.

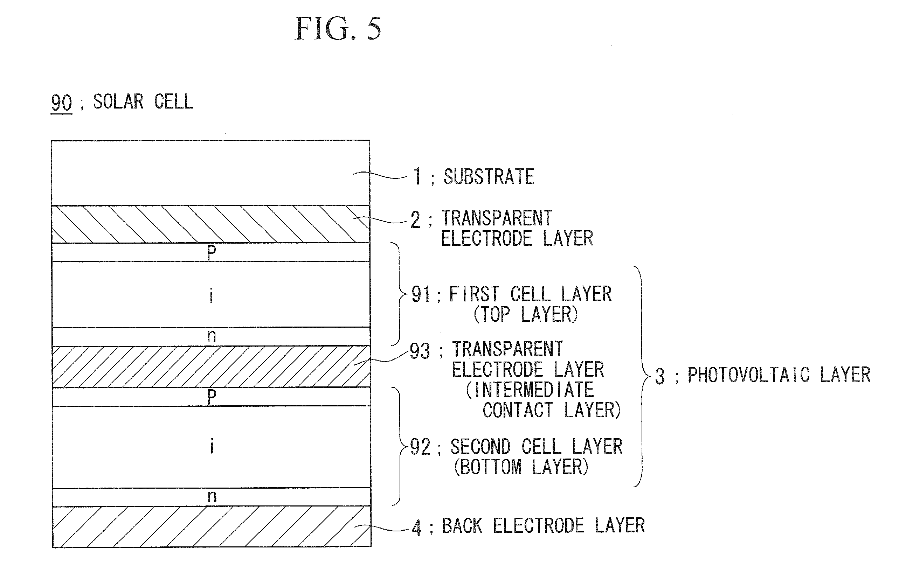

{Fig. 5} A longitudinal cross-sectional view illustrating a photovoltaic device according to an embodiment of the present invention.

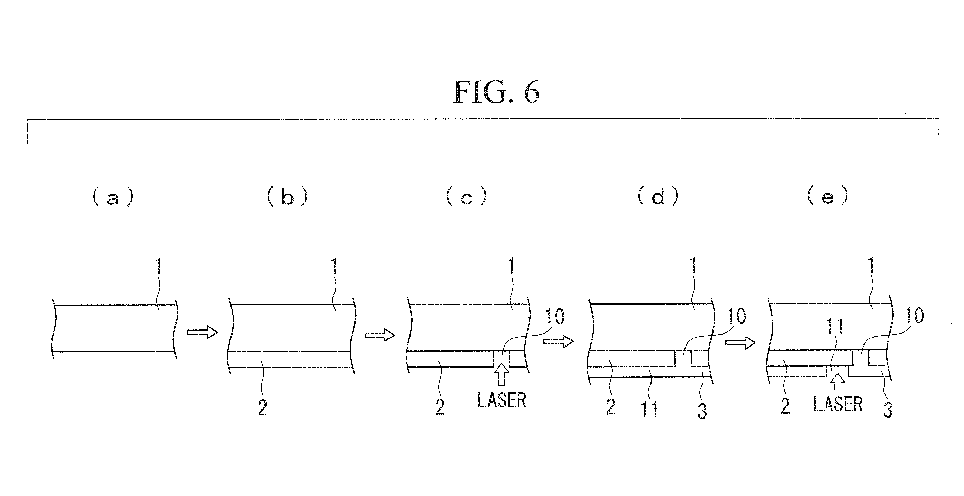

{Fig. 6} A schematic view illustrating part of a process for producing a solar cell panel according to an embodiment of the present invention.

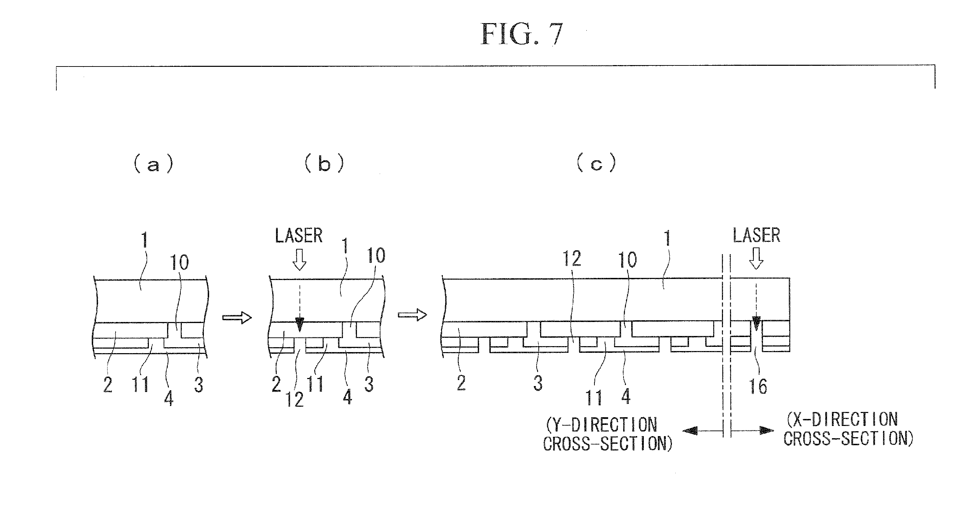

{Fig. 7} A schematic view illustrating part of a process for producing a solar cell panel according to an embodiment of the present invention.

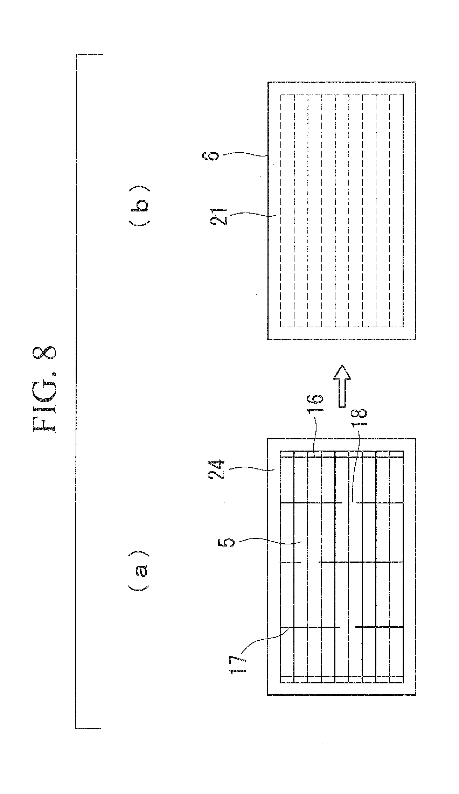

{Fig. 8} A schematic view illustrating part of a process for producing a solar cell panel according to an embodiment of the present invention.

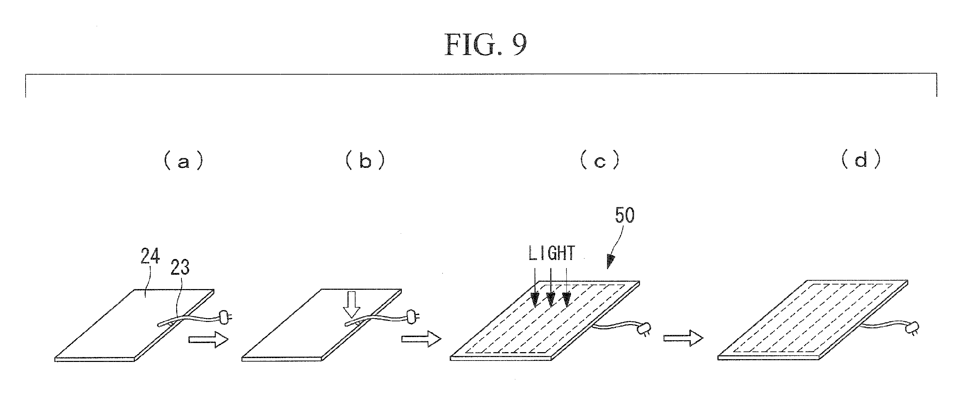

{Fig. 9} A schematic view illustrating part of a process for producing a solar cell panel according to an embodiment of the present invention.

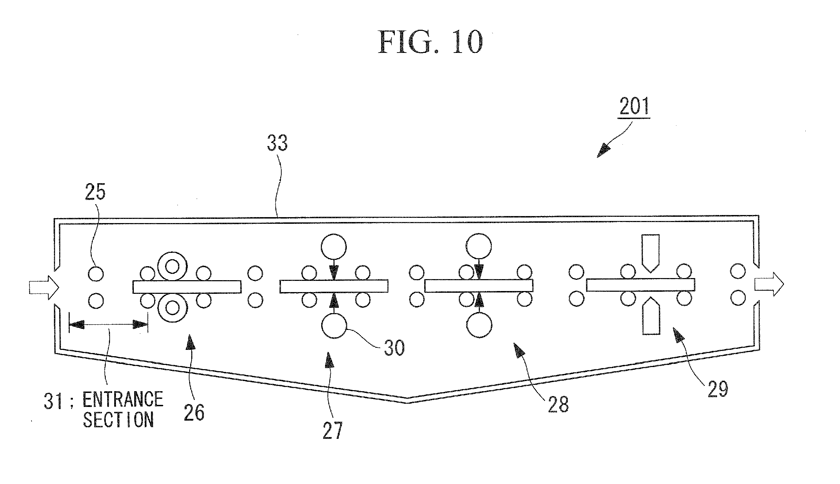

{Fig. 10} A side sectional view illustrating a substrate cleaning apparatus according to an embodiment of the present invention.

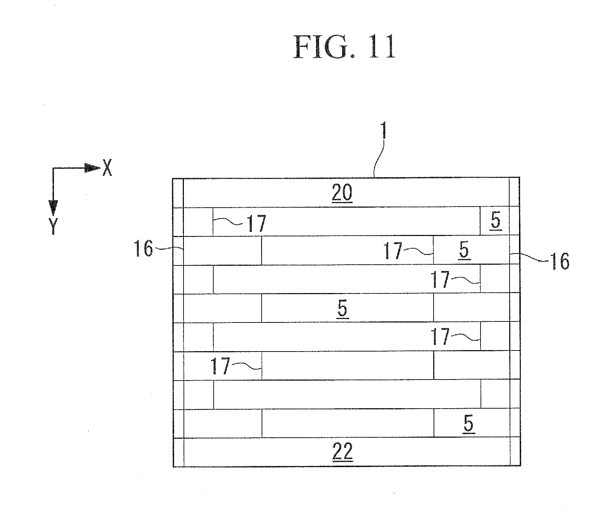

{Fig. 11} A plan view illustrating a modified example of a photovoltaic device according to an embodiment of the present invention.

Reference Signs List

1      Substrate
2      Transparent electrode layer
3      Photovoltaic layer
4      Back electrode layer
5      Solar cell unit cell (photovoltaic cell)
16    Side insulation slot (side insulation portion)
17    Intermediate insulation slot (intermediate insulation portion)
18    Conductive portion
90    Solar cell (photovoltaic device)

Description of Embodiments

An embodiment of the present invention is described below with reference to the drawings.

Fig. 1 is a plan view illustrating a solar cell that represents one embodiment of the photovoltaic device according to this embodiment.

The solar cell comprises a plurality of solar cell unit cells 5 (photovoltaic cells) on a substrate 1. The substrate 1 is a transparent substrate formed using glass or the like, and has a dimension in the X-direction shown in the figure (the second direction) of approximately 1.4 m, and a dimension in the Y-direction (the first direction) of approximately 1.1 m. A waterproof backing sheet (protective sheet) is bonded to the upper surface of the solar cell unit cells 5 with an adhesive filler sheet composed of EVA (ethylene vinyl acetate copolymer) or the like disposed therebetween, so as to cover the entire substrate 1.

Each solar cell unit cell 5 is a single unit that acts as an electric power generation region having a predetermined size, and as described below, comprises a transparent electrode layer, a photovoltaic layer and a back electrode layer. A single structure, a tandem structure or a triple structure may be used as the photovoltaic layer.

The solar cell unit cells 5 are connected in series in the Y direction (the first direction) from a positive electrode 20 towards a negative electrode 22. The Y-direction dimension of each solar cell unit cell 5 is approximately 11 mm, meaning a total of approximately 100 solar cell unit cells 5 are connected in series. Accordingly, it should be noted that in the figure, the dimensions of the solar cell unit cells 5 have been shown larger than true size in order to facilitate comprehension.

Side insulation slots (side insulation portions) 16 for achieving electrical insulation are formed in the vicinity of the sides of the substrate 1 that extend along the Y-direction. These side insulation slots 16 are provided in a continuous manner along the sides of the substrate 1. The side insulation slots 16 are slots in which the transparent electrode layer, the photovoltaic layer and the back electrode layer stacked on the substrate 1 have been removed, and the width of these slots is approximately 50 to 100 μm. Although not shown in the figure, insulation slots may also be formed in positions in the vicinity of the sides of the substrate 1 that extend along the X-direction. However, because a film polishing and removal treatment is performed to generate an insulation portion 24, these insulation slots in the vicinity of the sides that extend along the X-direction may be omitted.

The edge portion 24 that represents the region outside the side insulation slots 16 is a region in which grinding or the like is used to remove the transparent electrode layer, the photovoltaic layer and the back electrode layer formed on top of the substrate 1. However, performing removal of the photovoltaic layer and the like on the edge portion 24 along the side of the side insulation slots 16 having a width of approximately 50 to 100 μm is problematic in terms of maintaining dimensional precision, and therefore although only very small, portions of several mm of the transparent electrode layer, the photovoltaic layer and the back electrode layer tend to remain on the outside of the side insulation slots 16 (namely, within the edge portion 24). Furthermore, a film polishing and removal treatment of the edge portion 24 along the sides that extend in the X-direction is performed in the same manner as the Y-direction. The edge portion 24 acts as a bonding and sealing surface that is used for bonding the above-mentioned filler sheet and the backing sheet 21, thereby preventing moisture from penetrating the device from the periphery of the substrate 1.

Intermediate insulation slots (intermediate insulation portions) 17 that extend in the Y-direction are formed on the substrate center side of the side insulation slots 16. In a similar manner to the side insulation slot 16, these intermediate insulation slots 17 are slots in which the transparent electrode layer, the photovoltaic layer and the back electrode layer stacked on the substrate 1 have been removed, and the width of these slots is approximately 50 to 100 μm. As a result of these intermediate insulation slots 17, solar cell unit cells 5 that are positioned adjacently in the X-direction (the second direction) are electrically insulated from each other.

A plurality of the intermediate insulation slots 17 (three in this particular embodiment) are formed in parallel with a certain separation therebetween in the X-direction. In other words, two first intermediate insulation slots 17a are formed adjacent to the side insulation slots 16 formed at both sides of the substrate 1, and a single second intermediate insulation slot 17b is formed between these first intermediate insulation slots 17a. Each of the first intermediate insulation slots 17a is formed in a position at least 20 mm distant, in the X-direction, from the adjacent side insulation slot 16. In this embodiment a single second intermediate insulation slot 17b is provided, but two or more of these slots may also be used.

The intermediate insulation slots 17 are each divided at a position partway along the slot in the Y-direction. In other words, in these positions where the intermediate insulation slots 17 are divided, conductive portions 18 exist where the transparent electrode layer, the photovoltaic layer and the back electrode layer remain on the substrate. Accordingly, within these conductive portions 18, solar cell unit cells 5 that are positioned adjacently in the X-direction are electrically connected. However, solar cell unit cells 5 where a conductive portion 18 is positioned remain electrically insulated from another solar cell unit cell 5 positioned adjacently in the X-direction due to another intermediate insulation slot 17 positioned distantly from the conductive portion 18 in the X-direction. Specifically, a solar cell unit 5a in Fig. 1 is electrically connected to a solar cell unit cell 5b positioned adjacently in the X-direction via a conductive portion 18a. On the other hand, the solar cell unit cells 5a and 5b where the conductive portion 18a is positioned remain electrically insulated from a solar cell unit cell 5c positioned adjacently in the X-direction (namely, the left direction in the figure) as a result of the second insulation slot 17b. In this manner, the conductive portions 18 are arranged so that no solar cell unit cell 5 exists that extends from one side insulation slot 16 to the other side insulation slot 16 (unlike the solar cell unit cells 5 illustrated in Fig. 2). In other words, the conductive portion 18 provided within each intermediate insulation slot 17 is provided at a different position in the Y-direction from the conductive portion 18 provided in the adjacent intermediate insulation slot 17.

Next is a description of the longitudinal cross-sectional structure of the solar cell (photovoltaic device), based on Fig. 5. In this figure, the filler sheet and backing sheet 21 that are stacked on the back electrode layer 4 are omitted. The solar cell 90 is a silicon-based thin-film solar cell, and comprises a transparent substrate 1, a transparent electrode layer 2, a photovoltaic layer (or electric power generation layer) 3 comprising a first cell layer (a top layer ) 91 and a second cell layer (a bottom layer ) 92, and a back electrode layer 4. In this embodiment, the first cell layer 91 is a photovoltaic layer comprising mainly amorphous silicon-based semiconductors, and the second cell layer is a photovoltaic layer comprising mainly crystalline silicon-based semiconductors.

Here, the term "silicon-based" is a generic term that includes silicon (Si), silicon carbide (SiC) and silicon germanium (SiGe). Further, the term "crystalline silicon-based" describes a silicon system other than an amorphous silicon system, and includes both microcrystalline silicon and polycrystalline silicon systems.

An intermediate contact layer 93 formed from a transparent conductive film may be provided between the first cell layer 91 and the second cell layer 92.

The solar cell illustrated in Fig. 5 is a tandem structure comprising two stacked electric power generation layers composed of the first cell layer 91 and the second cell layer 92, but the present invention is not limited to tandem structures, and may also be used within single structures comprising a single electric power generation layer and triple structures comprising three stacked electric power generation layers.

Next is a description of a process for producing a solar cell panel comprising the solar cell described above and a backing sheet 21 and terminal box 23 connected to the solar cell. The description focuses on an example in which a photovoltaic layer comprising mainly amorphous silicon-based semiconductors and a photovoltaic layer comprising mainly crystalline silicon-based semiconductors are stacked sequentially, as the photovoltaic layer 3, on top of a glass substrate that functions as the substrate 1. Fig. 6 through Fig. 9 are schematic views illustrating the process for producing a solar cell and a solar cell panel according to this embodiment.

(1) Fig. 6(a)

A soda float glass substrate (1.4 m × 1.1 m × thickness: 4 mm) is used as the substrate 1. The edges of the substrate are preferably subjected to corner chamfering or R-face chamfering to prevent damage caused by thermal stress or impacts or the like.

(2) Fig. 6(b)

A transparent electrode layer 2 is formed on top of the substrate 1, thereby forming a transparent electrode-bearing substrate. In addition to the transparent electrode film, the transparent electrode layer 2 may include an alkali barrier film (not shown in the figure) formed between the substrate 1 and the transparent electrode film. The alkali barrier film is formed by using a thermal CVD apparatus to deposit a silicon oxide film ($SiO_2$) of not less than 50 nm and not more than 150 nm at a temperature of approximately 500°C.

(3) Fig. 6(c)

Subsequently, the substrate 1 is mounted on an X-Y table, and the first harmonic of a YAG laser (1064 nm) is irradiated onto the film surface of the transparent electrode film, as illustrated by the arrow in the figure. The laser power is adjusted to ensure an appropriate process speed, and the transparent electrode film is then moved in a direction perpendicular to the direction of the series connection of the electric power generation cells 5 (the X-direction in Fig. 1), thereby causing a relative movement of the substrate 1 and the laser light, and conducting laser etching across a strip having a predetermined width of not more than approximately 6 mm and not more than 12 mm to form a slot 10.

(4) Fig. 6(d)

Using a plasma CVD apparatus under conditions including a reduced pressure atmosphere of not less than 30 Pa and not more than 150 Pa, a substrate temperature of approximately 200°C, and a plasma RF generation frequency of not less than 13 MHz and not more than 100 MHz, a p-layer, i-layer and n-layer each formed from a thin film of amorphous silicon are deposited sequentially as the first cell layer (the top layer ) 91 of the photovoltaic layer 3. The first cell layer 91 is deposited on top of the transparent electrode layer 2 using $SiH_4$ gas and $H_2$ gas as the main raw materials. The p-layer, i-layer and n-layer are stacked in this order, with the p-layer closest to the surface from which incident sunlight enters.

In this embodiment, the p-layer of the first cell layer 91 is an amorphous B-doped SiC film generated by reaction of $SiH_4$, $H_2$, $CH_4$ and $B_2H_6$ gases using an RF plasma, and preferably has a thickness of not less than 4 nm and not more than 16 nm. The i-layer of the first cell layer 91 is preferably an amorphous Si film generated by reaction of $SiH_4$ and $H_2$ using an RF plasma, and preferably has a film thickness of not less than 100 nm and not more than 400 nm. The n-layer of the first cell layer 91 is a Si film containing a crystalline component, generated by reaction of $SiH_4$, $H_2$ and $PH_3$ gas using an RF plasma, and preferably has a film thickness of not less than 10 nm and not more than 80 nm. Furthermore, in order to suppress band mismatch at the interface between the p-layer (SiC film) and the i-layer (Si film), a substance with an intermediate band gap may be inserted as a buffer layer (not shown in the figure).

Next, using a plasma CVD apparatus under conditions including a reduced pressure atmosphere of not more than 3 kPa, a substrate temperature of approximately 200°C, and a plasma RF generation frequency of not less than 40 MHz and not more than 200 MHz, a microcrystalline p-layer, microcrystalline i-layer and microcrystalline n-layer each formed from a thin film of microcrystalline silicon are stacked sequentially, as the second cell layer (the bottom layer) 92, on top of the first cell layer 91.

In this embodiment, the p-layer of the second cell layer 92 is a Si film containing a crystalline component, generated by reaction of $SiH_4$, $H_2$ and $B_2H_6$ gases using an RF plasma, and preferably has a film thickness of not less than 10 nm and not more than 60 nm. The i-layer of the second cell layer 92 is a Si film containing a crystalline component, generated by reaction of $SiH_4$ and $H_2$ using an RF plasma, and preferably has a film thickness of not less than 1,200 nm and not more than 3,000 nm. The n-layer of the second cell layer 92 is a Si film containing a crystalline component, generated by reaction of $SiH_4$, $H_2$ and $PH_3$ gases using an RF plasma, and preferably has a film thickness of not less than 10 nm and not more than 80 nm.

During formation of the microcrystalline silicon thin films, particularly the microcrystalline i-layer by plasma CVD, the distance between the plasma discharge electrode and the surface of the substrate 1 is preferably not less than 3 mm and not more than 10 mm. If this distance is less than 3 mm, then the precision of the various structural components within the film deposition chamber required for processing large substrates means that maintaining the distance at a constant level becomes difficult, which increases the possibility of the electrode getting too close and making the discharge unstable. If the distance exceeds 10 mm, then achieving a satisfactory film deposition rate (of not less than 1 nm/s) becomes difficult, and the uniformity of the plasma also deteriorates, causing a deterioration in the quality of the film due to ion impact. The i-layer of the second cell layer 92 is preferably deposited under conditions including an RF frequency of not less than 40 MHz and not more than 200 MHz, a gas pressure of not less than 0.5 kPa and not more than 3 kPa, and a film deposition rate of not less than 1 nm/s and not more than 3 nm/s, and in this embodiment, film deposition is conducted using an RF frequency of 60 MHz, a gas pressure of 1.6 kPa, and a film deposition rate of 2 nm/s.

With the objective of forming a semi-reflective film to improve the contact properties and achieve electrical current consistency between the first cell layer 91 and the second cell layer 92, a ZnO-based film (such as a GZO (Ga-doped ZnO) film) with a film thickness of not less than 0 nm and not more than 90 nm may be deposited as an intermediate contact layer 93 using a sputtering apparatus.

(5) Fig. 6(e)

The substrate 1 is mounted on an X-Y table, and the second harmonic of a laser diode excited YAG laser (532 nm) is irradiated onto the film surface of the photovoltaic layer 3, as illustrated by the arrow in the figure. With the pulse oscillation set to not less than 10 kHz and not more than 20 kHz, the laser power is adjusted so as to achieve a suitable process speed, and laser etching is conducted at a target not less than approximately 100 $\mu$m and not more than 150 $\mu$m to the side of the laser etching line within the transparent electrode layer 2, so as to form a slot 11. Provided the positions of the laser etching lines are not inverted, no particular problems arise, but in consideration of positioning tolerances, the target is preferably set to a numerical value within the above range.

(6) Fig. 7 (a)

Using a sputtering apparatus, a Ag film is then deposited as the back electrode layer 4 under a reduced pressure atmosphere and at a temperature of approximately 150°C. In this embodiment, the Ag film of the back electrode layer 4 is deposited with a film thickness of not less than 150 nm, and in order reduce the contact resistance between the n-layer and the back electrode layer 4 and improve the reflectance, a ZnO-based film (such as a GZO (Ga-doped ZnO) film) with a film thickness of not less than 10 nm is provided between the photovoltaic layer 3 and the back electrode layer 4 using a sputtering apparatus.

(7) Fig. 7 (b)

The substrate 1 is mounted on an X-Y table, and the second harmonic of a laser diode excited YAG laser (532 nm) is irradiated onto the substrate 1, as illustrated by the arrow in the figure. The laser light is absorbed by the photovoltaic layer 3, and by using the high gas vapor pressure generated at this point, the back electrode layer 4 is removed by explosive fracture. With the pulse oscillation set to not less than 1 kHz and not more than 20 kHz, the laser power is adjusted so as to achieve a suitable process speed, and laser etching is conducted at a target not less than approximately 250 $\mu$m and not more than 400 $\mu$m to the side of the laser etching line within the transparent electrode layer 2, so as to form a slot 12. Provided the positions of the laser etching lines are not inverted, no particular problems arise, but in consideration of positioning tolerances, the target is preferably set to a numerical value within the above range.

Following removal of the back electrode layer 4, substrate cleaning is performed using a substrate cleaning apparatus 201 illustrated in Fig. 10. In those cases where the generation of residues (such as deposits and burrs) following removal of the back electrode layer 4 is minimal, this substrate cleaning step may sometimes be omitted. The inside of the substrate cleaning apparatus 201 is configured so that light of a wavelength that causes the photovoltaic layer to contribute significantly to electric power generation is not irradiated onto the photovoltaic layer, but rather only red-colored light is irradiated onto the photovoltaic layer. This red-colored light is composed mainly of a wavelength band in which the wavelength is not less than approximately 650 nm, and preferably not less than approximately 700 nm, and represents a wavelength band for which a solar cell comprising amorphous silicon as the photovoltaic layer exhibits only low photovoltaic sensitivity. Accordingly, a state of illumination can be achieved that enables operations inside the substrate cleaning apparatus 201 to be inspected visually, while suppressing electric power generation by the photovoltaic layer. Even in the case of a tandem solar cell in which the photovoltaic layer includes both amorphous silicon and crystalline silicon, because the electric power generation capability of the solar cell containing the amorphous silicon is very low under the red-colored light, electric power generation by the tandem solar cell can also be suppressed.

The substrate cleaning apparatus 201 has transport rollers 25 for transporting the substrate housed inside a main cover 33. Further, the substrate cleaning apparatus 201 also comprises, inside the main cover 33 and in sequence from the upstream side of the transport direction, an entrance section 31, a roller brush unit 26, a high-pressure shower unit 27, a direct water rinse unit 28, and an air knife unit 29. The roller brush unit 26 is sometimes not used in order to protect the photovoltaic layer, particularly in the case of cleaning deposited film surfaces.

The main cover 33 enables a state to be achieved in which red light represents the main illumination inside the apparatus, meaning light of a wavelength that causes the photovoltaic layer to contribute significantly to electric power generation is not irradiated onto the photovoltaic layer formed on the substrate being transported through the substrate cleaning apparatus 201. Internal room light and external light from entering the apparatus is blocked, and This red light is preferably generated by providing an illumination device that generates light of a wavelength band in which the wavelength is not less than approximately 650 nm, and preferably not less than approximately 700 nm. For example, this type of setup can be realized favorably by providing red-colored filters (sharp cut filters that block short wavelength light) that transmit light in a wavelength band of approximately 650 nm or greater, and preferably 700 nm or greater, on windows or gaps of the main cover 33 through which internal illumination or external light is able to enter. Gaps where internal and external light is able to enter the apparatus exist at the portions where the substrate enters and exits the cleaning apparatus, but the amount of light entering from these portions is minimal, and provided the amount of light inside the substrate cleaning apparatus 201 is restricted to a target of not more than 0.15 W/cm$^2$, electric power generation by the photovoltaic layer can be satisfactorily suppressed.

The above-mentioned amount of light is calculated from the number of atoms corresponding with the amount of electrodeposited metal (such as Ag) that poses a danger of short-circuiting the insulation slot when sunlight (white light) is irradiated onto the solar cell for a predetermined period of time.

Specifically, a numerical value for the upper limit for the above amount of light is calculated using a formula detailed below. Namely, in order to ensure that the amount of Ag deposition within the insulation slot is an amount that is insufficient to cause a short-circuit, the amount of light is preferably limited as follows:

```
Upper limit for amount of light < (charge amount required

for Ag deposition) ÷ (charge amount generated per unit amount

of light)
```

In this formula:

```
(charge amount required for Ag deposition) = (film

thickness of Ag film × cell width × deposition length ×

specific gravity/molecular weight × charge amount),
```

and

```
(charge amount generated per unit amount of light) =

(generated electrical current / amount of light × time).
```

Using the above formulas, if calculations are conducted assuming a Ag film thickness of 0.24 [nm] (the film thickness when single molecules of Ag are aligned), a cell width of 10 [mm], a deposition length of 0.1 [mm] (so that a length less than the insulation slot width is set as the amount of Ag deposition that does not cause a short-circuit), a specific gravity of 10.5 [g/cc], a molecular weight of 107.86 [g/mol], a charge amount of 6E23 [number/mol] × 1.6E-19 [C], a generated electrical current of 1.5 [A], an amount of light of 1,000 [W/m$^2$], and a time of 100 [s] (the contact time with water), then the following relationship can be obtained.

$$\text{Upper limit for amount of light} < 0.15 \text{ W/m}^2$$

Moreover, if the Ag deposition length is set to not more than 1/10th of the insulation slot width, then a more reliable suppression effect is obtained. In other words, the target for the amount of light is preferably set as follows

$$\text{Upper limit for amount of light} < 1.5 \times 10^{-2} \text{ W/m}^2$$

Roller brushes are provided in the roller brush unit 26. The roller brushes are provided both above and below the substrate undergoing treatment. The roller brushes are pressed against the substrate undergoing treatment, thereby scrubbing and cleaning the surfaces of the substrate undergoing treatment.

Nozzles for spraying high-pressure water are provided in the high-pressure shower unit 27. High-pressure water (for example, having a pressure of 0.2 to 1.0 MPa) is sprayed from these nozzles onto the substrate undergoing treatment. In this manner, in the high-pressure shower unit 27, cleaning is performed using water that is sprayed onto the substrate at high pressure.

Nozzles for spraying pure water are provided in the direct water rinse unit 28. Pure water (having a resistivity of not less than 10 M$\Omega$·cm) is sprayed from these nozzles onto the substrate undergoing treatment.

In the air knife unit 29, air is blown onto the substrate undergoing treatment. This removes water from the substrate undergoing treatment and dries the substrate.

(8) Fig. 7(c)

The electric power generation region is then compartmentalized, by using laser etching to remove the effect wherein the serially connected portions within the edge portion 24 of the substrate 1 (see Fig. 1) are prone to short-circuits. The substrate 1 is mounted on an X-Y table, and the second harmonic of a laser diode excited YAG laser (532 nm) is irradiated onto the substrate 1. The laser light is absorbed by the transparent electrode layer 2 and the photovoltaic layer 3, and by using the high gas vapor pressure generated at this point, the back electrode layer 4 is removed by explosive fracture, thereby removing the back electrode layer 4, the photovoltaic layer 3 and the transparent electrode layer 2. With the pulse oscillation set to not less than 1 kHz and not more than 10 kHz, the laser power is adjusted so as to achieve a suitable process speed, and laser etching is conducted at a point not less than approximately 5 mm and not more than 20 mm from the edge of the substrate 1, so as to form a Y-direction insulation slot 16. Fig. 7(c) represents a cross-sectional view cut along the direction of the series connection of the photovoltaic layer 3, and therefore the location in the figure where the Y-direction insulation slot 16 is formed should actually appear as an edge portion 24 in which the back electrode layer 4, the photovoltaic layer 3 and the transparent electrode layer 2 have been removed by film polishing (see Fig. 8(a)), but in order to facilitate description of the processing of the edges of the substrate 1, the insulation slot formed in this location is described as a Y-direction insulation slot 16.

Further, another method of forming the Y-direction insulation slot 16 is described below. Namely, the substrate 1 is mounted on an X-Y table, and the first harmonic of a laser diode excited YAG laser (1064 nm) is irradiated onto the substrate 1. The laser light is absorbed by and vaporizes the transparent electrode layer 2, and by using the high gas vapor pressure generated at this point, even within the photovoltaic layer 3, the back electrode layer 4 is removed by explosive fracture, thereby removing the back electrode layer 4, the photovoltaic layer 3 and the transparent electrode layer 2. Subsequently, the second harmonic of a YAG laser (532 nm) is irradiated onto the substrate 1 together with the above first harmonic of the YAG laser, thereby removing any residues (deposits or burrs) of the back electrode layer 4, the photovoltaic layer 3 and the transparent electrode layer 2. With the pulse oscillation set to not less than 1 kHz and not more than 20 kHz, the laser power is adjusted so as to achieve a suitable process speed, and laser etching is conducted at a point not less than approximately 5 mm and not more than 15 mm from the edge of the substrate 1, so as to form the Y-direction insulation slot 16.

Completing the etching of the Y-direction insulation slot 16 at a position not less than 5 mm and not more than 10 mm from the edge of the substrate 1 is preferred, as it ensures that the Y-direction insulation slot 16 is effective in inhibiting external moisture from entering the interior of the solar cell module 6 via the edges of the solar cell panel.

Although the laser etching treatments up until this point has been specified as using a YAG laser, a YVO4 laser or fiber laser or the like may also be used in a similar manner.

In a similar manner to the Y-direction insulation slot 16, intermediate insulation slots 17 (see Fig. 1) are formed in the Y-direction by laser etching. When forming the intermediate insulation slots 17, a conductive portion 18 is provided that divides the slot at a position partway along each slot. The intermediate insulation slots 17 are preferably not provided within the series-arranged solar cell unit cells 5 positioned along the two edges of the solar cell module 6. This ensures that when, in a subsequent step (see (10) Fig. 8b), processing is performed to extract the electrical power from each of these solar cell unit cells 5 along the two edges, even if some locations exist where a favorable electrical contact cannot be ensured between the current collecting copper foil and each of the solar cell unit cells 5 along the two edges, current collection by the copper foil can still be performed favorably due to the fact that the back electrode layer 4 has not been divided for each of the solar cell unit cells 5 along the two edges.

A side insulation slot need not be provided in the X-direction in the same manner as the Y-direction insulation slots 16, because a film polishing and removal treatment is performed within the edge portion 24.

Examples of the method used for providing the conductive portion 18 by dividing each of the intermediate insulation slots 17 at a position partway along the slot include the methods outlined below.

(i) Methods that employ a blocking mask to block the laser

Specifically, a blocking mask may be installed using one of the methods (a) to (d) described below.

(a) The substrate 1 is mounted and positioned on a process stage (X-Y table), and a blocking mask (composed of a combination of metal foil and metal wire) is installed that covers the entire surface of the module that is to be irradiated with laser light. The blocking mask may be positioned during the step of positioning the substrate.

(b) An adhesive tape is bonded to the laser incident side of the substrate 1 for the purpose of blocking the laser light in those portions that are to become the conductive portions 18. The adhesive tape is removed following completion of the laser processing and exit of the substrate form the processing apparatus.

(c) A volatile liquid (such as water or alcohol) is dripped onto the laser incident side of the substrate 1, within blocking regions in which the conductive portions 18 are to be formed, thereby scattering the laser light and weakening the laser light to an energy level insufficient to effect etching. The volatile liquid (such as water or alcohol) is eliminated naturally over time, meaning a mask removal step is unnecessary.

(d) A water-soluble substance (such as sodium bicarbonate) is applied to blocking regions in which the conductive portions 18 are to be formed, thereby scattering the laser light. The water-soluble substance can be removed in the cleaning apparatus employed in a subsequent step.

(ii) Methods that block the laser light

Specific examples of methods of blocking the laser light include the methods (a) to (c) described below.

(a) A mechanical shutter is inserted within the light path. Alternatively, the optical system light axis is finely altered using a reflective mirror or the like.

(b) The laser excitation pulse is blocked (to adjust the oscillation of the intermittent pulse laser), and is synchronized with the movement of the process stage.

(c) The focus lens is driven in synchronization with the movement of the process stage so that the laser light density at the processing surface is insufficient to effect film etching.

Following formation of the insulation slots 16 and 17 in the manner described above, the substrate may be cleaned using the substrate cleaning apparatus 201 illustrated in Fig. 10, in an environment in which internal and external light is blocked and red-colored light acts as the main illumination.

(9) Fig. 8(a)

In order to ensure favorable adhesion and sealing of a backing sheet 21 via EVA or the like in a subsequent step, the stacked films within the edge portion 24 of the substrate 1 are removed, as they tend to be uneven and prone to peeling. First, grinding or blast polishing or the like is performed to remove the back electrode layer 4, the photovoltaic layer 3, and the transparent electrode layer 2 from a region that is not less than 5 mm and not more than 20 mm from the edge of the substrate, and is closer to the substrate edge than the insulation slots 16 provided in the step of Fig. 7 (c) described above.

Following completion of polishing in the manner described above, the substrate is cleaned using the substrate cleaning apparatus 201 illustrated in Fig. 10, in an environment in which internal and external light is blocked and red-colored light acts as the main illumination.

(10) Fig. 8 (b)

An attachment portion for a terminal box 23 is prepared by providing an open through-window in the backing sheet 21 and exposing a collecting plate. A plurality of layers of an insulating material are provided in the open through-window portion in order to prevent external moisture and the like entering the solar cell.
Processing is conducted so as to enable current collection, using a copper foil, from the series-connected solar cell electric unit cell 5 at one end and the solar cell unit cell 5 at the other end, and to enable electric power to be extracted from a terminal box portion on the rear surface of the solar cell panel. In order to prevent short-circuits between the copper foil and the various portions, an insulating sheet that is wider than the width of the copper foil is provided.
Following arrangement of the collecting copper foil and the like at predetermined positions, a sheet of a filling material such as EVA (ethylene vinyl acetate copolymer) is arranged so as to cover the entire substrate 1 but not protrude beyond the substrate 1.
A backing sheet 21 with a superior waterproofing effect is positioned on top of the EVA. In this embodiment, in order to achieve a superior waterproofing and moisture-proofing effect, the backing sheet 21 is formed as a three-layer structure comprising a PET sheet, Al foil, and a PET sheet.
The structure comprising the components up to and including the backing sheet 21 arranged in predetermined positions is subjected to internal degassing under a reduced pressure atmosphere and pressing at approximately 150°C using a laminator, thereby causing cross-linking of the EVA that tightly seals the structure.

(11) Fig. 9(a)

A terminal box 23 is attached to the rear surface 24 of the solar cell module 6 using an adhesive.

(12) Fig. 9(b)

The copper foil and an output cable from the terminal box are connected using solder or the like, and the interior of the terminal box is filled and sealed with a sealant (a potting material). This completes the production of the solar cell panel 50.

(13) Fig. 9(c)

The solar cell panel 50 formed via the steps up to and including Fig. 9(b) is then subjected to an electric power generation test, as well as other tests for evaluating specific performance factors. The electric power generation test is conducted using a solar simulator that emits a standard sunlight of AM 1.5 (1,000 W/m$^2$).

(14) Fig. 9(d)

In tandem with the electric power generation test (Fig. 9(c)), a variety of specific performance factors including the external appearance are evaluated.
The production process outlined above describes a solar cell using the example of a tandem solar cell having an amorphous silicon-based photovoltaic layer as the top cell and a crystalline (microcrystalline) silicon-based photovoltaic layer as the bottom cell, but the present invention is not limited to this example.
For example, the present invention can also be applied in a similar manner to other types of thin-film solar cells, including single solar cells containing only an amorphous silicon-based photovoltaic layer as the photovoltaic layer, single solar cells containing only a crystalline silicon-based photovoltaic layer of microcrystalline silicon or the like, and multi-junction solar cells in which either one, or two or more, other photovoltaic layers are provided in addition to the top cell and bottom cell described above.
The effects of employing the solar cell and the production process according to the embodiment described above are described below.
Because the intermediate insulation slots 17 are provided on the substrate center side of the side insulation slots 16, the solar cell unit cells adjacent to a side insulation slot 16 are limited in area to the surface area from the side insulation slot 16 to the adjacent intermediate insulation slot 17. Accordingly, even if a short-circuit occurs within the side insulation slot 16 as a result of water penetration or the like, only an electric power generation current equivalent to the surface area from the side insulation slot 16 to the intermediate insulation slot 17 is leaked into the edge portion 24 of the substrate 1.
Specifically, even if moisture penetrates from the edge of the substrate 1, either as a result of degradation over time in the filler sheet and backing sheet 21 bonded to the substrate 1, or as a result of a deterioration in the waterproofing properties of the bonded portions, causing the formation of water W within a side insulation slot 16 as illustrated in Fig.

1, the leakage current that flows as a result of the short-circuit caused by the water W is limited to the electrical current accumulated in a solar cell unit cell 5d compartmentalized by the first intermediate insulation slot 17a. In contrast, in a solar cell described in the background art and illustrated in Fig. 2, the electrical current accumulated within a large surface area solar cell unit cell that extends from the side insulation slot 16 on one side of the module to the side insulation slot 16 on the other side flows as a leakage current, meaning electrodeposition is more likely to occur, thereby increasing the likelihood of short-circuits. In this manner, in the embodiment of the present invention, the provision of the intermediate insulation slots 17 reduces the leakage current generated when a short-circuit occurs, meaning short-circuits caused by electrodeposition can be dramatically suppressed.

Furthermore, by providing a conductive portion 18 in a position partway along each intermediate insulation slot 17, the adjacent solar cell unit cells 5 on either side of this position are electrically connected. This means that the electric power generation current can also flow in the X-direction through this conductive portion 18, meaning the electrical current can flow not only to the solar cell unit cell 5 positioned adjacently in the Y-direction, but also via the conductive portion 18 to the solar cell unit cell 5 positioned adjacently in the X-direction. Accordingly, even if an ineffective cell that does not contribute to electric power generation exists in the Y-direction, another solar cell unit cell 5 positioned adjacently in the X-direction can be used, meaning deterioration in the performance of the photovoltaic device can be prevented as far as possible.

Specifically, as illustrated in a comparative example in Fig. 4, a module can be prepared in which four sub-modules 7 are provided by forming three intermediate insulation slots 19 that are continuous in the Y-direction and include no conductive portions. If water W is formed within the side insulation slot 16 that forms one edge of a first sub-module 7a positioned on the right side in the figure, then the solar cell unit cell 5d corresponding with this water W short-circuits, causing a leakage current I to flow, and as a result, no electric power generation current flows through the first sub-module 7a. Furthermore, if, as illustrated within a third sub-module 7c positioned third from the right side in the figure, one of the solar cell unit cells 5f within the sub-module is a faulty cell which, due to the state of the film deposition or the presence of shade or dirt, is unable to contribute to electric power generation, then no electric power generation current will flow through the third sub-module 7c. Accordingly, in the case of the solar cell illustrated in Fig. 4, as illustrated by the dashed arrows in the figure, electrical current is only able to flow through the second sub-module 7b and the fourth sub-module 7d.

In contrast, in the embodiment of the present invention, as illustrated in Fig. 1, even if a solar cell unit cell 5f becomes a faulty cell due to the state of the film deposition or the presence of shade or dirt, because a conductive portion 18 is provided upstream in the Y-direction from this faulty solar cell unit cell 5f, the electric power generation current is able to flow in the X-direction through this conductive portion 18, thereby avoiding the faulty solar cell unit cell 5f (see the dashed arrows in Fig. 1). As a result, the solar cell unit cells upstream in the Y-direction from the faulty solar cell unit cell 5f can still be effectively utilized, meaning any deterioration in the performance of the solar cell can be largely suppressed.

As in the present embodiment, the back electrode layer 4 and the transparent electrode layer 2 preferably remain within the conductive portion 18. However, a region in which only the back electrode layer 4 remains or a region in which only the transparent electrode layer 2 remains can also be used as the conductive portion 18.

Furthermore, the solar cell unit cells 5 where a conductive portion 18 is positioned remain electrically insulated from another solar cell unit cell 5 positioned adjacently in the X-direction due to another intermediate insulation slot 17. As a result, solar cell unit cells (such as those illustrated in Fig. 2) having a comparatively large surface area that are formed in a continuous manner from one side insulation slot 16 through to the other side insulation slot 16 can be avoided, thereby suppressing the size of the electrical current that flows when a short-circuit occurs within a side insulation slot 16 as a result of water penetration or the like, and largely avoiding short-circuits caused by electrodeposition.

Furthermore, because the intermediate insulation slots 17 are formed not less than 20 mm distant from the side insulation slots 16, even if moisture crosses a side insulation slot 16 and penetrates into the module, the adjacent intermediate insulation slot 17 can block any adverse effects caused by the short-circuit, and those solar cell unit cells 5 positioned on the inside of the intermediate insulation slot 17 can continue to be used. According to investigations conducted by the inventors of the present invention and others, provided that the intermediate insulation slots 17 are 20 mm distant from the side insulation slots 16, then even in those cases where the protective sheet degrades and water penetrates as far as the side insulation slots 16, the intermediate insulation slots 17 are able to block adverse effects caused by short-circuits to such an extent that 10 or more years are required before short-circuits due to water penetration or performance deterioration caused by cell degeneration become problematic.

Further, in large solar cells where the length along one side exceeds 1 m, the present invention is effective even in single structures having a single electric power generation layer as it yields increased electric power generation capacity.

Moreover, solar cells having a tandem structure with two stacked electric power generation layers or a triple structure with three stacked electric power generation layers have larger electric power generation capacities than solar cells having a single structure with one electric power generation layer, and therefore the potential leakage current is larger, meaning an increased chance of electrodeposition. Accordingly, in the case of a solar cell having a tandem structure or a triple structure, a solar cell comprising intermediate insulation slots 17 and conductive portions 18, such as the solar cell of the present embodiment, is particularly effective.

In the present invention, the pattern in which the intermediate insulation slots 17 are formed is not restricted to the pattern illustrated in Fig. 1. For example, as illustrated in Fig. 11, the intermediate insulation slots 17 may be formed in a regular repeating pattern that alternates for each solar cell unit cell 5 in the Y-direction.

Furthermore, the inside of the substrate cleaning apparatus 201 used in the substrate cleaning step is maintained in a state in which light of a wavelength that causes the solar cell unit cells 5 to contribute significantly to electric power generation is irradiated to the solar cell 5, with only red-colored light used for illumination. As a result, not only is an electric potential sufficient to cause electrodeposition not generated within those insulation portions that have been short-circuited as a result of water that has adhered during the cleaning step, but the red-colored light enables operations inside the substrate cleaning apparatus to be checked visually. Accordingly, any chance that electrodeposition may occur during the production process for the solar cell, causing a short-circuit, can be effectively eliminated.

**Claims**

1. A photovoltaic device comprising a plurality of photovoltaic cells, which are formed on top of a substrate and are connected in series in a first direction, and
side insulation portions, which are formed continuously in a vicinity of sides of the substrate that extend along the first direction, and electrically insulate the photovoltaic cells from an edge portion of the substrate, wherein
two or more intermediate insulation portions that electrically insulate the photovoltaic cells positioned adjacently in a second direction that is substantially orthogonal to the first direction are formed on a substrate center side of the side insulation portions so as to extend in the first direction in a parallel arrangement across the second direction,
a conductive portion that electrically connects the photovoltaic cells positioned adjacently in the second direction is provided in a position partway along each of the intermediate insulation portions, and
the photovoltaic cells where the conductive portion is positioned are electrically insulated from a photovoltaic cell positioned adjacently in the second direction by another of the intermediate insulation portions positioned distant from the conductive portion in the second direction.

2. The photovoltaic device according to claim 1, wherein the intermediate insulation portions comprise:

    two first intermediate insulation portions, each provided next to one of the side insulation portions formed along both sides of the substrate, and
    at least one second intermediate insulation portion provided between the first intermediate insulation portions.

3. The photovoltaic device according to claim 1 or 2, further comprising a protective sheet that covers an entire surface of the substrate so as to protect the photovoltaic cells formed on top of the substrate, wherein
the intermediate insulation portions are positioned not less than 20 mm distant from the side insulation portions.

4. The photovoltaic device according to any one of claims 1 to 3, wherein
the photovoltaic cells exist within a tandem structure comprising two stacked photovoltaic layers, or within a triple structure comprising three stacked photovoltaic layers.

5. A process for producing a photovoltaic device comprising:

    an insulation step of forming an insulation portion that electrically insulates a photovoltaic layer formed on a substrate from other regions, and
    a cleaning step of cleaning the substrate following the insulation step, wherein
    for a predetermined period including the cleaning step, the photovoltaic layer is illuminated with a red-colored light.

6. The process for producing a photovoltaic device according to claim 5, wherein the photovoltaic device is the photovoltaic device according to any one of claims 1 to 4.

# FIG. 1

# FIG. 2

# FIG. 3

22

103

I

# FIG. 4

X

Y

7d  19  7c  24  19  7b  19  7a

20

16

16

5d

W

24

22

I

5f

24

# FIG. 5

90 ; SOLAR CELL

1 ; SUBSTRATE

2 ; TRANSPARENT ELECTRODE LAYER

91 ; FIRST CELL LAYER (TOP LAYER)

93 ; TRANSPARENT ELECTRODE LAYER (INTERMEDIATE CONTACT LAYER)

92 ; SECOND CELL LAYER (BOTTOM LAYER)

3 ; PHOTOVOLTAIC LAYER

4 ; BACK ELECTRODE LAYER

EP 2 187 449 A1

# FIG. 6

(a)　　　(b)　　　(c)　　　(d)　　　(e)

EP 2 187 449 A1

FIG. 7

(a)

(b)

(c)

(X-DIRECTION CROSS-SECTION)

(Y-DIRECTION CROSS-SECTION)

LASER

# FIG. 8

(a)                          (b)

# FIG. 9

（a）    （b）    （c）    （d）

# FIG. 10

FIG. 11

## INTERNATIONAL SEARCH REPORT

| | International application No. |
|---|---|
| | PCT/JP2007/065870 |

A. CLASSIFICATION OF SUBJECT MATTER
*H01L31/042*(2006.01)i

According to International Patent Classification (IPC) or to both national classification and IPC

B. FIELDS SEARCHED

Minimum documentation searched (classification system followed by classification symbols)
H01L31/042

Documentation searched other than minimum documentation to the extent that such documents are included in the fields searched
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2001-68714 A  (Kaneka Corp.),<br>16 March, 2001 (16.03.01),<br>Par. Nos. [0039], [0051]; Fig. 3<br>(Family: none) | 1-6 |
| Y | JP 10-209477 A  (Kaneka Corp.),<br>07 August, 1998 (07.08.98),<br>Full text; all drawings<br>(Family: none) | 1-6 |
| Y | JP 2001-111071 A  (Kaneka Corp.),<br>20 April, 2001 (20.04.01),<br>Full text; all drawings<br>& EP 1089346 A2        & AU 2000-20725 A<br>& US 6578764 B1 | 1-6 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>12 November, 2007 (12.11.07) | Date of mailing of the international search report<br>20 November, 2007 (20.11.07) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2007/065870

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2001-127319 A (Kaneka Corp.), 11 May, 2001 (11.05.01), Full text; all drawings (Family: none) | 1-6 |

Form PCT/ISA/210 (continuation of second sheet) (April 2007)

## INTERNATIONAL SEARCH REPORT

| International application No. |
| --- |
| PCT/JP2007/065870 |

**Box No. II  Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III  Observations where unity of invention is lacking (Continuation of item 3 of first sheet)**

This International Searching Authority found multiple inventions in this international application, as follows:
   The "special technical feature" of the invention of claim 1 relates to "a photoelectric conversion device having an intermediate insulating portion formed therein", and the "special technical feature" of the invention of claim 5 relates to "a method for manufacturing a photoelectric conversion device, comprising the step of irradiating a red light".
   These inventions cannot be considered so relative as to form a single general inventive concept, since they are not so technically related as to involve one or two or more of the same or corresponding special technical features.

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**
the

☐ The additional search fees were accompanied by the applicant's protest and, where applicable, payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

**EP 2 187 449 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI11312816 B
- JP HEI10209477 B